# EUROPÄISCHE PATENTANMELDUNG

(11) **EP 0 607 842 A1**
(43) Veröffentlichungstag der Anmeldung: **27.07.1994**
(21) Anmeldenummer: 94100302.2
(22) Anmeldetag: 11.01.1994
(51) Int. Cl.: H05K 7/14

(54) **Einstückiges, auf mindestens einer Seite mittels einer Metallschicht metallisiertes Isolierteil**

(30) Priorität: 22.01.1993 DE 9300870 U
(71) Anmelder: SIEMENS AKTIENGESELLSCHAFT, D-80333 München (DE)
(72) Erfinder: Schönberger, Eduard, Dipl.-Ing., D-92245 Kümmersbruck (DE); Kasowski, Hermann, Dipl.-Ing., D-92280 Kastl (DE); Gruber, Stefan, Dipl.-Ing., D-92245 Kümmersbruck (DE); Schmidt, Heinz, Dipl.-Ing., D-92245 Kümmersbruck (DE)

(57) **Zusammenfassung**

Spritzgießteile (1,2) mit integrierten Leiterzügen (3,4) sind bekannt. Eine besonders einfache und sichere elektrische Kontaktierung des Spritzgießteils (1) mit einem weiteren Element (2) ergibt sich, wenn eines der Spritzgießteile (1) Zapfen (13) aufweist, die Kontaktflächen (9) aufweisen und von einer Seite des Spritzgießteils (1) abstehen. Die Kontaktfläche (9) ist dabei mit einem der Leiterzüge (3,4) verbunden.

## Beschreibung

Die vorliegende Erfindung betrifft ein Isolierteil gemäß dem Oberbegriff des Anspruchs 1. Ein derartiges Isolierteile ist beispielsweise aus der EP-0 465 692 A1 bekannt. Auch beim Automatisierungsgerät SIMATIC S5-95 U der Siemens AG wird ein derartiges Isolierteil als Gehäuserückwand verwendet.

Die Aufgabe der vorliegenden Erfindung besteht darin, eine möglichst einfache und billige Möglichkeit zum Kontaktieren eines weiteren, vorzugweise parallel zur metallisierten Seite anzuordnenden Bauteils zu schaffen.

Die Aufgabe wird durch das Kennzeichen des Anspruchs 1 gelöst.

Durch die Ausbildung gemäß Anspruch 2 können Toleranzen ausgeglichen werden, so daß sich ein sicherer Kontakt ergibt. Durch die Ausbildung gemäß Anspruch 3 wird der Raumbedarf für den als Kontaktelement dienenden Zapfen minimiert. Wenn die Kontaktfläche des Zapfens mindestens eine Kontaktnoppe aufweist, ergibt sich ein besonders sicherer, Toleranzen noch weiter ausgleichender Kontakt.

Bei Ausbildung des Isolierteils gemäß Anspruch 5 kann eine Vielzahl von Kontaktstellen auf kleinem Raum angeordnet werden. Es ergibt sich dadurch eine Kompaktheit ähnlich einem Vielfachstecker. Weiterhin ermöglicht diese Anordnung, ein Befestigungselement zentral zur Achse zu stecken und so den elektrischen Kontakt besonders zuverlässig herzustellen.

Weitere Vorteile und Einzelheiten ergeben sich aus der nachfolgenden Beschreibung eines Ausführungsbeispiels. Dabei zeigen:

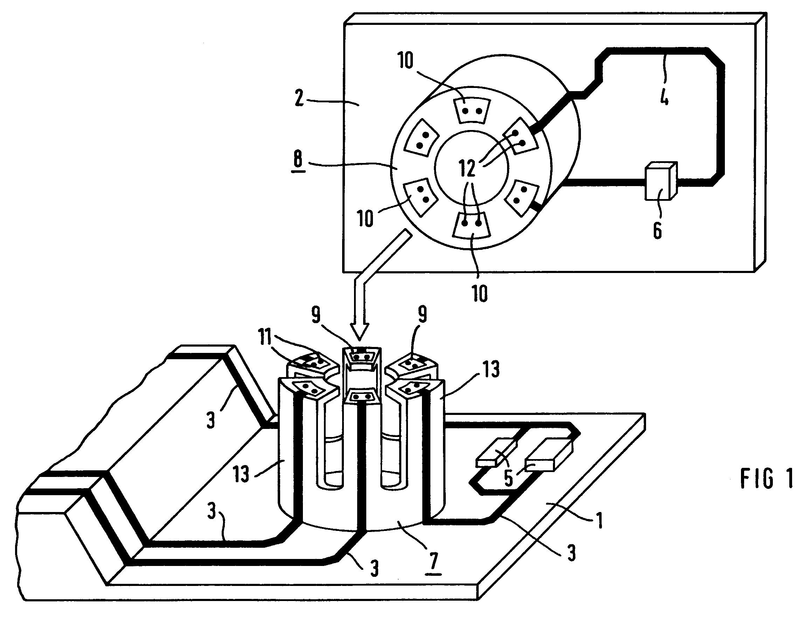

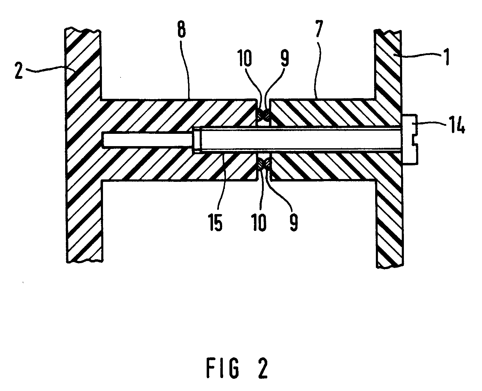

- FIG 1 und 2: je zwei miteinander zu verbindende Kunststoffteile.

Die in FIG 1 und FIG 2 gezeigten Spritzgießteile 1, 2 sind gemäß eines an sich bekannten und üblichen Herstellungsverfahrens hergestellt und auf ihren einander zugewandten Seiten in an sich bekannter Weise mit einer Metallschicht beschichtet, also metallisiert. Nach der Metallisierung wurde an Stellen, an denen keine Metallisierung erwünscht ist, die Metallschicht entfernt, z. B. mittels eines Lasers oder durch Ätzen. Dadurch entstehen elektrisch voneinander getrennte Gebiete 3, 4, die die Funktion von Leiterzügen haben. Die Spritzgießteile 1, 2 sind daher mit symbolisch angedeuteten Bauelementen 5, 6 bestückbar.

Mindestens eines der Spritzgießteile 1, 2 weist einen Kontaktdom 7, 8 auf, der an seiner Oberseite Kontaktflächen 9, 10 mit Kontaktnoppen 11, 12 aufweist. Zumindest einer der Kontaktdome 7, 8 ist segmentiert, so daß er in mehrere L-förmige Zapfen 13 aufgeteilt ist. Wie insbesondere aus FIG 2 ersichtlich ist, stehen die Zapfen 13 im wesentlichen senkrecht, also in einem Winkel von mindestens 60°, von der metallisierten Seite ab.

Mittels der Segmentierung des einen Kontaktdoms 7 wird ein gewisser Toleranzausgleich erreicht, wenn die Spritzgießteile 1, 2 mittels der Schraube 14 miteinander verbunden werden, da die einzelnen Zapfen 13 sich etwas elastisch verbiegen können, also federnd ausgebildet sind. Die Schraube 14 kann dabei z. B. in ein Gewinde 15 eingeschraubt werden, das im Kontaktdom 8 angeordnet ist. Ebenso könnte das Gewinde aber auch in der Fläche des Spritzgießteils 2 angeordnet sein. Selbstverständlich sind auch andere Formen der Befestigung, z. B. mittels interner oder externer Rasthaken, sowie andere Zapfenformen, z. B. Z-förmig, denkbar.

Durch die räumliche Nähe von mechanischer Befestigung und elektrischen Kontaktstellen wird, insbesondere in Verbindung mit dem Toleranzausgleich durch die Zapfen 13 und die Kontaktnoppen 11, 12, ein besonders sicherer elektrischer Kontakt geschaffen.

Anstelle von Spritzgießteilen 1, 2 können auch andere einstückige, auf ihrer Oberfläche zunächst elektrisch isolierende Schaltungsträger verwendet werden, z. B. auf ihren gesamten Oberflächen in geeigneter Weise eloxierte Aluminium-Druckgußteile.

## Patentansprüche

1. Einstückiges, zumindest auf seiner Oberfläche elektrisch isolierendes, auf mindestens einer Seite mittels einer Metallschicht metallisiertes Isolierteil, z. B. Kunststoffteil, insbesondere Spritzgießteil, wobei die Metallschicht in mehrere elektrisch voneinander getrennte Gebiete aufgeteilt ist, **dadurch gekennzeichnet,** daß die metallisierte Seite mindestens einen Zapfen (13) aufweist, der an seinem von der metallisierten Seite abgewandten Ende mindestens eine Kontaktfläche (9) zum elektrischen Kontaktieren mit einem mit dem Kunststoffteil (1) elektrisch und mechanisch zu verbindenden Bauteil (2) aufweist und daß die Kontaktfläche (9) elektrisch leitend mit einem der elektrisch voneinander getrennten Gebiete (3) verbunden ist.

2. Isolierteil nach Anspruch 1, **dadurch gekennzeichnet,** daß der Zapfen (13) federnd ausgebildet ist.

3. Isolierteil nach Anspruch 2, **dadurch gekennzeichnet,** daß der Zapfen (13) im wesentlichen L-förmig ausgebildet ist und im wesentlichen senkrecht von der metallisierten Seite absteht.

4. Isolierteil nach Anspruch 1, 2 oder 3, **dadurch gekennzeichnet,** daß die Kontaktfläche (9) mindestens eine Kontaktnoppe (11) oder eine Kontaktmulde aufweist.

5. Isolierteil nach Anspruch 1, 2, 3 oder 4, **dadurch gekennzeichnet,** daß es eine Vielzahl von Zapfen (13) aufweist und daß die Zapfen (13) um eine senkrecht auf der metallisierten Fläche stehende Achse herum angeordnet sind.

6. Isolierteil nach einem der obigen Ansprüche, **dadurch gekennzeichnet,** daß es als mit einer Isolierschicht versehenes Metallteil, z. B. als eloxiertes Aluminium-Druckgußteil, ausgebildet ist.
